(19) Europäisches Patentamt
European Patent Office
Office européen des brevets

(11) **EP 2 560 030 B1**

(12) **FASCICULE DE BREVET EUROPEEN**

(45) Date de publication et mention
de la délivrance du brevet:
**29.01.2014  Bulletin 2014/05**

(51) Int Cl.:
***G01V 99/00*** *(2009.01)*

(21) Numéro de dépôt: **12290226.5**

(22) Date de dépôt: **09.07.2012**

(54) **Méthode pour construire un modèle géologique comportant une mise en position de depot d'unites stratigraphiques**

Methode zum Erstellen eines geologischen Modells, die eine Positionierung des Lagers aus stratigrafischen Einheiten umfasst

Method for building a geologic model comprising the placement of stratigraphic units in deposition position

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **17.08.2011  FR 1102530**

(43) Date de publication de la demande:
**20.02.2013  Bulletin 2013/08**

(73) Titulaire: **IFP Energies Nouvelles
92852 Rueil Malmaison Cedex (FR)**

(72) Inventeurs:
- **Poudret, Mathieu
  75005 Paris (FR)**
- **Bennis, Chakib
  92500 Rueil-Malmaison (FR)**
- **Rainaud, Jean-François
  78112 Fourqueux (FR)**

(56) Documents cités:
**US-A1- 2002 091 502     US-A1- 2011 106 507**

- **MORETTI I ET AL: "Kine3D : a new restoration method based on a mixedapproach linking geometry and geomechanics", OIL & GAS SCIENCE AND TECHNOLOGY - REVUE DE L'INSTITUT FRANCAISDU PETROLE, EDITIONS TECHNIP, PARIS, FR, vol. 61, no. 2, 1 janvier 2006 (2006-01-01), pages 277-289, XP002583702, ISSN: 0020-2274**
- **MORETTI ET AL: "Working in complex areas: New restoration workflow based on quality control, 2D and 3D restorations", MARINE AND PETROLEUM GEOLOGY, BUTTERWORTH SCIENTIFIC, GUILDFORD, GB, vol. 25, no. 3, 18 février 2008 (2008-02-18), pages 205-218, XP022489005, ISSN: 0264-8172, DOI: 10.1016/J.MARPETGEO. 2007.07.001**

EP 2 560 030 B1

**EP 2 560 030 B1**

**Description**

La présente invention concerne le domaine technique de l'industrie pétrolière, et l'exploitation de formations souterraines, tels que des réservoirs pétroliers, des sites de stockage de gaz, ou des bassins.

En particulier, l'invention permet de construire une image de la formation souterraine, appelée modèle géologique par les spécialistes, ou mettre à jour une telle image pour la rendre cohérente avec les différentes données collectées sur le terrain.

L'optimisation et l'exploitation de formations souterraines reposent sur une description aussi précise que possible de la structure, des propriétés pétrophysiques, des propriétés des fluides, etc., de la formation étudiée. Pour ce faire, les spécialistes utilisent un outil qui permet de rendre compte de ces aspects de façon approchée : le modèle géologique. Un tel modèle constitue une maquette du sous-sol, représentative à la fois de sa structure et de son comportement. Généralement, ce type de maquette est représenté sur un ordinateur, et l'on parle alors de modèle numérique. Un modèle géologique comporte un maillage ou grille, généralement tridimensionnelle, associée à une ou plusieurs cartes de propriétés pétrophysiques (porosité, perméabilité, saturation...). L'association consiste à attribuer des valeurs de ces propriétés pétrophysiques à chacune des mailles du maillage. Ainsi, un modèle géologique, représenté sur un ordinateur, consiste en une grille à N dimensions (N>0 et en général égale deux ou trois) dont chacune des mailles se voit affecter la valeur d'une propriété caractéristique de la zone étudiée. Il peut s'agir par exemple de la porosité ou de la perméabilité distribuée dans un réservoir.

Ces modèles bien connus et largement utilisés dans l'industrie pétrolière, permettent de déterminer de nombreux paramètres techniques relatifs à l'étude ou l'exploitation d'un réservoir, d'hydrocarbures par exemple. En effet, puisque le modèle géologique est représentatif de la structure du réservoir et de son comportement, l'ingénieur l'utilise par exemple pour déterminer les zones qui ont le plus de chances de contenir des hydrocarbures, les zones dans lesquelles il peut être intéressant/nécessaire de forer un puits d'injection ou de production pour améliorer la récupération des hydrocarbures, le type d'outils à utiliser, les propriétés des fluides utilisés et récupérés... Ces interprétations de modèles de réservoir en termes de «paramètres techniques d'exploitation» sont bien connues des spécialistes, même si de nouvelles méthodes sont régulièrement développées. De la même façon, la modélisation des sites de stockages de $CO_2$ permet de surveiller ces sites, de détecter des comportements anormaux et de prédire le déplacement du $CO_2$ injecté.

Les formations géologiques sont en général des milieux très hétérogènes, comportant des surfaces sédimentaires déformées, découpées et décalées par des failles. De ce fait, les maillages du modèle géologique sont des objets très complexes, comportant des mailles déformées, des surfaces sédimentaires, délimitant des unités stratigraphiques, découpées ou déformées par des failles. Une telle complexité est généralement représentée au moyen de maillages, dits « maillages stratigraphiques ».

Pour construire le modèle géologique il faut alors remplir ce maillage stratigraphique avec des propriétés caractéristiques de la formation souterraine. On utilise pour ce faire des simulations géostatistiques dont le principe est rappelé ci-après.

La valeur d'une propriété caractéristique de la zone étudiée est appelée variable régionalisée. Il s'agit d'une variable continue, distribuée dans l'espace, et représentative d'un phénomène physique. Du point de vue mathématique, il s'agit simplement d'une fonction z(u) prenant une valeur en chaque point u (la maille de la grille) d'un domaine d'étude D (la grille représentative du réservoir). Mais la variation de la variable régionalisée dans cet espace est trop irrégulière pour pouvoir être formalisée par une équation mathématique. En fait, la variable régionalisée représentée par z(u) possède à la fois un aspect global, relatif à la structure spatiale du phénomène étudié, et un aspect local aléatoire.

Ce dernier aspect, local aléatoire, peut être modélisé par une variable aléatoire (VA). Une variable aléatoire est une variable qui peut prendre un certain nombre de réalisations z suivant une certaine loi de probabilité. Des variables continues telles que des attributs sismiques (impédance acoustique) ou des propriétés pétrophysiques (saturation, porosité, perméabilité) peuvent être modélisées par des VA. De ce fait, au point u, la variable régionalisée z(u) peut être considérée comme la réalisation d'une variable aléatoire Z.

Cependant, pour représenter correctement la variabilité spatiale de la variable régionalisée, il faut pouvoir prendre en compte le double aspect, à la fois aléatoire et structuré. Une des approches possibles, de type probabiliste, fait appel à la notion de fonction aléatoire. Une fonction aléatoire (FA) est un ensemble de variables aléatoires (VA) définies sur un domaine d'étude D (la grille représentative du réservoir), c'est-à-dire {Z(u), u * D}, également noté Z(u). Ainsi tout groupe de valeurs échantillonnées {z(u1),...,z(un)} peut être considéré comme une réalisation particulière de la fonction aléatoire Z(u) = {Z(u1),...,Z(un)}. La FA Z(u) permet de prendre en compte à la fois l'aspect localement aléatoire (en u*, la variable régionalisée z(u*) étant une VA) et l'aspect structuré (via la loi de probabilité spatiale associée à la FA Z(u)).

Les réalisations d'une fonction aléatoire associées à un maillage fournissent des modèles géologiques stochastiques. A partir de tels modèles, il est possible d'apprécier le mode de fonctionnement de la zone souterraine étudiée. Par exemple, la simulation des écoulements dans un milieu poreux représenté par des modèles stochastiques numériques, permet entre autre, de prédire la production du réservoir et ainsi d'optimiser son exploitation en testant différents scenarii.

Cependant, il est très difficile de réaliser des simulations géostatistiques sur des maillages stratigraphiques, qui pourtant sont les meilleurs outils pour représenter correctement la géométrie complexe d'une formation souterraine. En effet, ces méthodes sont basées sur une estimation des distances, et notamment l'estimation de variogramme. Or il est très difficile de réaliser une telle estimation sur un maillage stratigraphique.

Pour remplir, un maillage stratigraphique au moyen de simulation géostatistique, on connaît différents procédés.

Par exemple, une première méthode consiste a définir, dans un espace géographique au temps « actuel » une grille 3D régulière (I,J,K) non cartésienne avec un échantillonnage vertical équivalent à l'échantillonnage des mesures de propriétés le long des trajectoires de forage (maillage stratigraphique fin) et ayant pour caractéristique d'appuyer les surfaces K=Constante sur une surface de référence (toit du réservoir, base du réservoir ou surface quelconque). Ces méthodes constituent ensuite un espace de calcul géostatistique en définissant une grille cartésienne ayant le même nombre de cellules que le maillage stratigraphique fin pour lequel les dimensions des mailles sont égales à la moyenne des dimensions des mailles du maillage stratigraphique fin. C'est sur cette grille que s'effectuent les opérations de remplissage géostatistiques.

Cependant, cette méthode est sensible aux choix définis pour la constitution du maillage stratigraphique, ce qui peut amener des distorsions qui sont néfastes à la qualité des résultats obtenus. Notamment, ces méthodes ne permettent pas d'estimer avec précision des distances pour définir un variogramme, outil indispensable aux simulations géostatistiques.

D'autres méthodes, dites « implicites », permettent de remplir un maillage stratigraphique de façon globale. Le principe de l'approche implicite est de construire une fonction 3D F=f(x, y, z) de telle façon qu'une interface géologique soit alors définie comme une surface isovaleur particulière F0 de la fonction F. Le modèle n'est pas stocké explicitement sous forme de pixels ou voxels, mais on le rend explicite en l'interrogeant « à la volée » pour savoir dans quelle formation on se situe en tout point (x, y, z). Cette «interrogation» n'est pas un ré-échantillonnage du modèle à partir d'une image discrétisée. C'est un calcul exact du modèle au point considéré. Cependant, ces méthodes implicites obligent de reconstruire le modèle en totalité. Ces techniques sont décrites par exemple dans les documents suivants :

- Lajaunie, Ch. et al., 1997, "Foliation fields and 3d cartography in geology:principles of a method based on potential interpolation", Mathematical Geology, 29 (4), 571-584

- Calcagno, P. et al., 2008, "Geological modelling from field data and geological knowledge - Part I. Modelling method coupling 3D potentialfield interpolation and geological rules.", Physics of the Earth and Planetary Interiors, Vol. 171, No. 1-4, pp. 147-157

- Mallet, J. L., 2004, "Space-time mathematical framework for sedimentary geology.", Mathematical Geology 36, N.1

- Dulac J.C., 2009, "Advances in chrono-stratigraphic interpretation modelling", First Break Volume 27

- Les demandes de brevets WO2005/119304 et WO2003/050766.

Les documents US 2011/0106507 A1 et US 2002/0091502 A1 divulguent des méthodes pour construire des modèles géologiques.

Ainsi, l'objet de l'invention concerne une méthode alternative pour construire un modèle géologique représentatif d'une formation souterraine. La méthode s'affranchit des problèmes des méthodes antérieures, en réalisant une mise en position de dépôt d'une surface de référence appartenant à une unité stratigraphique, puis en réalisant un calage des surfaces mises en position de dépôt par rapport à leur surface de référence. On peut alors réaliser de simulations géostatique pour remplir cette unité par une propriété caractéristique de la formation.

La méthode selon l'invention permet de ne mettre à jour qu'une partie du modèle géologique (une seule unité stratigraphique) sans avoir à estimer les propriétés pour l'ensemble du maillage stratigraphique.

De plus, la méthode permet une précision accrue dan l'estimation des distances pour définir le variogramme, outil indispensable aux simulations géostatistiques.

**La méthode selon l'invention**

De façon générale, l'invention concerne une méthode de construction d'une image d'une formation souterraine traversée par au moins un puits, ladite image comportant un maillage stratigraphique comportant au moins une unité stratigraphique délimitée par une surface supérieure et une surface inférieure et représentant une couche sédimentaire homogène, ladite unité stratigraphique comportant un ensemble de mailles, chaque maille étant définie par un ensemble de noeuds, dans laquelle on mesure au moins une propriété caractéristique de la formation au niveau dudit puits. La méthode comporte les étapes suivantes :

    i. on réalise une mise en position de dépôt de ladite unité stratigraphique, en déterminant une position des noeuds de mailles de ladite unité au moment du dépôt d'au moins une surface de référence contenue dans ladite unité stratigraphique, en réalisant les étapes suivantes :

        a. on réalise un dépliage isométrique d'au moins ladite surface de référence ;

        b. on définit une rotation et une translation à appliquer à ladite surface dépliée au moyen d'une minimisation de distances entre un ensemble de points de la surface de référence et des points correspondants dans ladite surface dépliée, et l'on applique ladite rotation et ladite translation à ladite surface dépliée, de façon à obtenir une superposition de ladite surface dépliée avec ladite surface de référence ;

        c. on utilise ladite superposition pour réaliser un contrôle visuel de la mise en position de dépôt, puis on applique le même dépliage au sein de ladite unité stratigraphique ;

    ii. on superpose une grille cartésienne régulière sur ladite unité stratigraphique mise en position de dépôt ;

    ii. on attribue une valeur de ladite propriété caractéristique de la formation à chaque maille de ladite grille, à partir de ladite mesure au puits, du puits mis en position de dépôt et d'une simulation géostatistique ;

    iv. on reporte lesdites valeurs attribuées aux mailles de la grille dans les mailles dudit maillage stratigraphique.

Selon l'invention, on peut choisir l'ensemble de points de la surface de référence en choisissant des sommets de la surface de référence, chaque sommet ne se situant ni sur une faille, ni dans une région érodée.

On peut positionner la surface de référence dépliée dans un espace tridimensionnel, en calculant une profondeur moyenne d'un ensemble de sommets de la surface de référence, et en attribuant à l'ensemble des sommets de la surface dépliée cette profondeur moyenne.

Selon un mode de réalisation, on réalise la mise en position de dépôt de l'unité stratigraphique au moyen d'un dépliage isométrique de deux surfaces de référence, suivi d'un calage de chaque surface dépliée par rapport à la surface de référence correspondante et d'un second calage par rotation et translation des deux surfaces de références dépliées l'une par rapport à l'autre, et d'un dépliage proportionnel de surfaces contenues entres les deux surfaces de référence. Les deux surfaces de références peuvent correspondre à la surface supérieure et la surface inférieure.

Selon ce mode de réalisation, on peut réaliser le second calage, en définissant la rotation et la translation à appliquer à une première surface dépliée au moyen d'une minimisation de distances entre un ensemble de points de ladite première surface dépliée et des points correspondants dans ladite seconde surface dépliée, et l'on applique ladite rotation et ladite translation à ladite première surface dépliée, de façon à obtenir une superposition desdites surfaces dépliées.

Selon l'invention, on peut réaliser un dépliage isométrique en prenant en compte des failles de la formation, en pratiquant une fermeture de lèvres de failles.

Enfin, selon l'invention, les surfaces peuvent être des surfaces triangulées.

D'autres caractéristiques et avantages de la méthode selon l'invention, apparaîtront à la lecture de la description ci-après d'exemples non limitatifs de réalisations, en se référant aux figures annexées et décrites ci-après.

**Présentation succincte des figures**

- La figure 1 montre illustre les étapes de la méthode selon l'invention

- La figure 2A illustre un maillage stratigraphique dans le repère géographique (x, y, z).

- La figure 2B illustre un maillage cartésien régulier correspondant à la mise en position de dépôt du maillage stratigraphique de la figure 2A.

- La figure 3 illustre le procédé de mise en position de dépôt par projection verticale

- La figure 4 illustre le procédé de mise en position de dépôt par dépliage isométrique à partir d'une surface de référence.

- La figure 5 illustre le procédé de mise en position de dépôt par dépliage isométrique à partir de deux surfaces de référence.

- La figure 6 illustre la projection verticale d'un point $p_i$ de l'espace géologique (EG), et le calcul de sa position dans l'espace de dépôt (ED) en fonction de la surface de référence (SR).

- La figure 7 illustre le résultat du dépliage isométrique d'une surface.

- La figure 8 illustre le dépliage de trois horizons contenu dans une grille.

- La figure 9 illustre la mise en correspondance des deux lèvres de chaque faille lors de la mise à plat d'une surface.

- La figure 10 illustre le dépliage isométrique du maillage stratigraphique (à gauche) conduisant à l'espace de dépôt (à droite) selon la méthode de dépliage isométrique à partir d'une surface de référence.

- La figure 11 illustre le fait que les surfaces dépliées résultantes de la méthode de mises à plat ne sont pas placées dans le même repère

- La figure 12 explique le principe de calage des surfaces de référence.

- La figure 13 montre les 16 cas possibles.

- La figure 14 illustre le résultat de l'extraction d'une surface d'une grille stratigraphique.

- La figure 15A illustre une mise en position de dépôt avec une méthode connue de l'art antérieur.

- La figure 15B illustre une mise en position de dépôt avec la méthode de projection verticale.

- La figure 15C illustre une mise en position de dépôt avec la méthode de dépliage isométrique.

- La figure 16A illustre une unité stratigraphique U, en position géographique.

- La figure 16B illustre le toit et la base de l'unité stratigraphique U, en position dépliée.

- La figure 17 illustre la superposition, après calage, d'une unité stratigraphique en position géographique et de cette même unité en position de dépôt dans un même espace.

**Description détaillée de la méthode**

La méthode selon l'invention permet la construction ou la mise à jour d'un modèle géologique (image d'une formation souterraine) représentatif d'une formation souterraine traversée par au moins un puits.
A partir de ce puits, on mesure au moins une propriété caractéristique de la formation le long de la trajectoire du puits. Puis, on étend cette information mesurée le long de la trajectoire de puits sur la totalité d'un maillage stratigraphique. Ce maillage et cette information en chaque maille, constitue une image d'une formation souterraine, appelée modèle géologique.

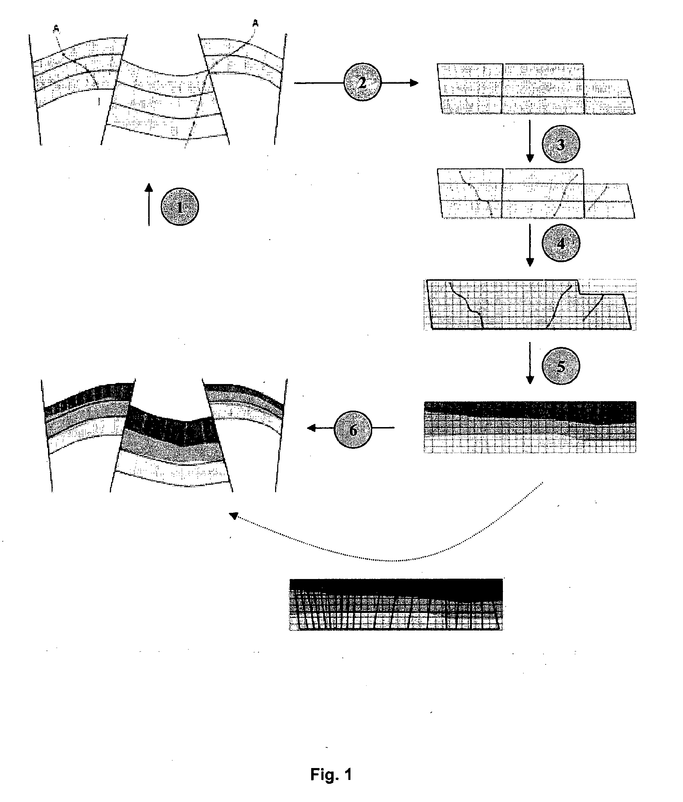

La figure 1 illustre les étapes de la méthode selon l'invention, après avoir acquis des mesures le long de la trajectoire d'un puits :

1. Construction d'au moins une unité stratigraphique

2. Mise en position de dépôt de l'unité stratigraphique et calage par rapport à l'unité stratigraphique d'origine

3. Mise en position de dépôt de la trajectoire du puits

4. Superposition d'une grille cartésienne régulière

5. Remplissage de la grille cartésienne régulière par simulation géostatistique

6. Report des propriétés de la grille cartésienne vers le maillage stratigraphique.

1. Construction d'au moins une unité stratiaraphiaue

On construit un maillage stratigraphique, discrétisant la formation souterraine, et représentatif de la structure (agencement des couches sédimentaires, failles, ...) de cette formation à l'instant présent. Ce maillage stratigraphique est défini dans un repère orthonormé (x, y, z), appelé repère géographique. Ainsi, chaque maille du maillage stratigraphique est repérée, à l'instant actuel, par des coordonnées géographiques x, y et z (profondeurs). Ainsi, l'unité stratigraphique comporte un ensemble de mailles, chaque maille étant définie par un ensemble de noeuds.

Ce maillage stratigraphique découpe la formation souterraine un ensemble d'unité stratigraphique, définie par l'intervalle entre deux surfaces sédimentaires, appelées horizons. Ainsi, l'image de la formation comporte un maillage stratigraphique comportant au moins une unité stratigraphique délimitée par une surface supérieure et une surface inférieure et représentant une couche sédimentaire homogène.

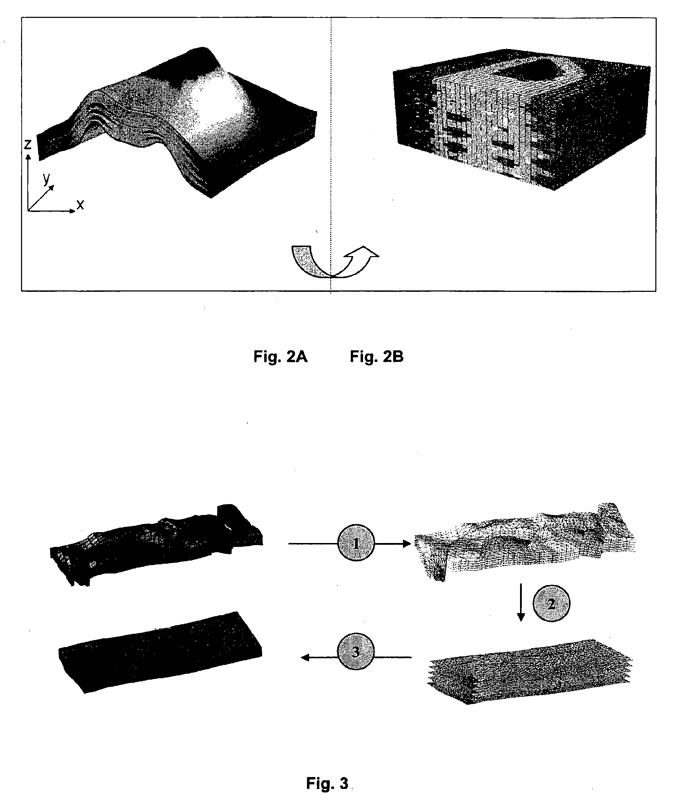

La construction d'un tel maillage stratigraphique est bien connue des spécialistes. La figure 2A illustre un tel maillage dans le repère géographique (x, y, z).

Les étapes 2 à 7 suivantes sont réalisées pour au moins une unité stratigraphique. En effet, selon l'invention, on peut avantageusement travailler unité stratigraphique par unité stratigraphique. Bien entendu, pour remplir l'ensemble du modèle géologique, on réitère chaque étape (2 à 7) pour toutes les unités stratigraphiques du modèle géologique.

2. Mise en position de dépôt de l'unité stratigraphique et calage de la surface dépliée par rapport à la surface de référence

L'affectation à chaque maille d'une propriété caractéristique de la formation, telle que la porosité, la perméabilité,... est appelé remplissage. Cette étape est réalisée au moyen de simulateur géostatique (logiciel) à partir de données mesurées au sein de la formation (diagraphies, sismiques). Ce type de simulateur est plus performant et fiable lorsqu'ils sont utilisés sur des maillages cartésiens réguliers.

Pour construire ce maillage, on réalise une mise en position de dépôt du maillage stratigraphique. Cette étape consiste à affecter à chaque point repéré par des coordonnées à un instant actuel, des coordonnées à un instant antérieur, cet instant correspond au dépôt de l'unité stratigraphique traitée. Il s'agit donc de "déformer" les horizons contenus dans l'unité en position de dépôt (avant déformation au cours de l'histoire sédimentaire et tectonique). Ceci revient à restaurer la formation souterraine, c'est-à-dire à parcourir vers le passé son histoire tectonique (plissement, jeux des failles).

Selon l'invention, on ne reconstitue pas de façon incrémentale l'histoire, pour reculer progressivement de l'état actuel vers l'état paléogéographique initial, mais on transporte en une étape unique des points caractéristiques de la formation (marqueur au toit, à la base le long d'une trajectoire de puits, positions des points de mesure échantillonnés par les logs). Il s'agit de réaliser une mise en position de dépôt de l'unité stratigraphique, en déterminant une position des noeuds et centres de mailles formant cette unité au moment du dépôt.

La figure 2B illustre le résultat d'une mise en position de dépôt du maillage stratigraphique de la figure 2A.

Pour réaliser cette étape, la méthode selon l'invention utilise indépendamment deux alternatives. Soit on réalise la mise en position de dépôt au moyen d'une projection verticale, soit on réalise la mise en position de dépôt au moyen d'un dépliage isométrique.

2.1 Mise en position de dépôt d'au moins une unité stratigraphique par projection verticale.

La figure 3 illustre le procédé utilisé. Celui-ci comporte les étapes suivantes :

i) Extraction et triangulation de l'ensemble des surfaces contenues dans l'unité

ii) Projection verticale dans un plan 2D de l'ensemble des surfaces

iii) Construction de l'espace de dépôt à partir des surfaces planes obtenues.

Cette méthode permet le calcul d'une mise en position de dépôt d'un maillage stratigraphique par projections verticales. Les données d'entrée de cet algorithme sont : une surface de référence (choisie par l'utilisateur), un ensemble de failles, et un ensemble de points à mettre en position de dépôt. L'algorithme fournit l'ensemble des points en position de dépôt.

Dans un premier temps, les données d'entrée doivent respecter les hypothèses suivantes :

- la surface à partir de laquelle les points du maillage stratigraphique sont mis en position de dépôt est appelée la surface de référence. Elle est notée S.

- des failles $F_1$,..., Fi découpent des volumes au sein du maillage stratigraphique. Ces failles sont également des surfaces triangulées.

- chaque formation géologique peut être composée de plusieurs volumes connexes (les failles peuvent déconnecter les volumes).

- on appelle "espace géologique" (EG), l'espace défini par le maillage stratigraphique, c'est-à-dire l'unité stratigraphique avant mise en position de dépôt.

- on appelle "espace de dépôt" (ED), l'unité stratigraphique après mise en position de dépôt.

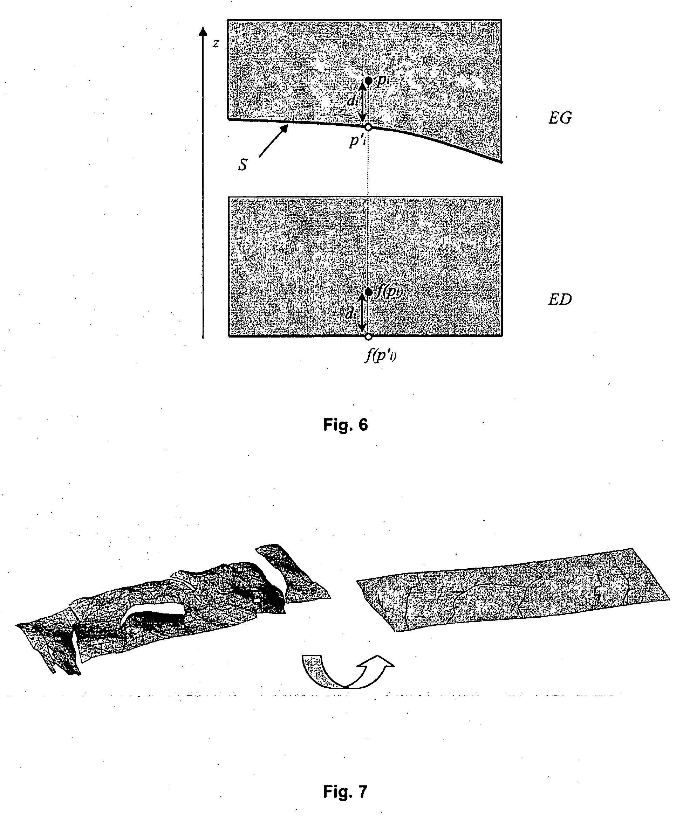

Un plan orthogonal à l'axe z est choisi (pour la suite du détail de l'algorithme, on choisit z = 0). Chaque point pi = $(x_i, y_i, z_i)$ d'un espace géologique est projeté verticalement (selon l'axe z) sur la surface de référence S (figure 6). On note $p'_i$ le projeté de $p_i$ sur S et $d_i$ la longueur du segment $[p_i, p'_i]$. L'image du point $p_i$ dans l'espace de dépôt est défini par : $f(p_i)=(x_i, y_i, d_i)$. La figure 6 illustre la projection verticale d'un point $p_i$ de l'espace géologique (EG), et le calcul de sa position dans l'espace de dépôt (ED) en fonction de la surface de référence (S).

Selon un mode de réalisation, on gère la présence de faille de la façon suivante. Des problèmes peuvent survenir localement autour des failles, lorsque celles-ci empêchent de projeter $p_i$ sur S. On dit alors que *pi* est situé dans une *zone d'incertitude.*

Un point *p* d'un espace géologique est en une zone d'incertitude si et seulement si il n'existe aucun point $q \in$ *S* vérifiant les deux conditions suivantes :

- *q* est sur la droite de projection verticale de *p* (i.e. *p* et *q* ont les mêmes coordonnées en *x* et en *y*),

- le segment $[p,q]$ n'intersecte pas de faille

Pour les points situés en zone d'incertitude possédant au moins un projeté vertical sur S, la solution suivante permet d'assurer les propriétés de voisinage entre les points de l'espace géologique et les points de l'espace de dépôt :

Soit $p_i = (x_i, y_i, d_i)$, un point d'une zone d'incertitude, nous associons à $p_i$, un point $p'_i$ où $p'_i$ est le point du bord de S le plus proche de *pi* tel que le segment $[p_i, p'_i]$ n'intersecte aucune faille. On calcule le plan tangent à *S* au point $p'_i$ (on le note $T(S, p'_i)$). Le point $p_i$ est alors projeté verticalement sur $T(S, p'_i)$ en un point $t_i = (xt_i, yt_i, zt_i)$. Soit $d_i$ la longueur du segment $[p_i, t_i]$. L'image du point *pi* dans l'espace de dépôt est alors défini par : $f(p_i)=(x_i, y_i, d_i)$ où $X_i = xt_i$ et $y_i = yt_i$.

Selon un autre mode de réalisation, on gère d'éventuels problèmes de précision numérique de la façon suivante. Les données d'entrée (horizons et failles) peuvent présenter des problèmes d'imprécision qui peuvent être dus à des problèmes de précision numérique ou bien liés aux données elles mêmes. Par exemple, des jeux de données peuvent comporter des points d'un horizon pouvant "déborder" de l'autre côté d'une faille. Dans ce cas, ils ne se trouvent pas du bon côté de la faille, le calcul de sa projection sera donc faussé. Après avoir déterminé le point p' du bord de S, le plus proche en x, y du point p à déposer, on s'assure qu'aucune faille n'intersecte le segment [p,p']. En pratique, on calcule un point p" à partir de p'. Ce point p" est calculé à partir des barycentres des triangles incidents à p'. Le point p" est donc le point p' "décalé vers l'intérieur de la surface". Les erreurs liées à la précision numérique sont alors évitées. En pratique, nous effectuons un prétraitement à tous les sommets du bord de la surface de référence afin de contracter cette surface.

## 2.2 Mise en position de dépôt d'au moins une unité stratigraphique par-dépliage isométrique.

Le principe du dépliage isométrique est le suivant : à partir d'une surface 3D pliée, une surface dépliée (i.e. 2D) dans laquelle les déformations sont minimales est construite. Le critère choisi pour minimiser la déformation est le tenseur de déformation élastique.

Au cours de la déformation, l'ensemble des composantes "Z" est calculé afin d'obtenir une surface plane. Au niveau des failles, les deux lèvres sont mises en correspondances et lissées afin de "boucher" les trous au niveau celle-ci. Pour cela, l'information de correspondance des noeuds au niveau des lèvres de failles et conservée lors de l'opération d'extraction de surface. La figure 7 illustre le résultat du dépliage isométrique d'une surface.

Pour réaliser cette étape, on peut utiliser une ou deux surfaces de références.

Pour ce type de méthode, Il faut pouvoir associer à chaque sommet de SR les noeuds de la grille. Grace a une structure du maillage stratigraphique par pilier on a directement cette correspondance. Ce type de maillage est bien connu des spécialistes.

## Dépliage isométrique d'une seule surface de référence

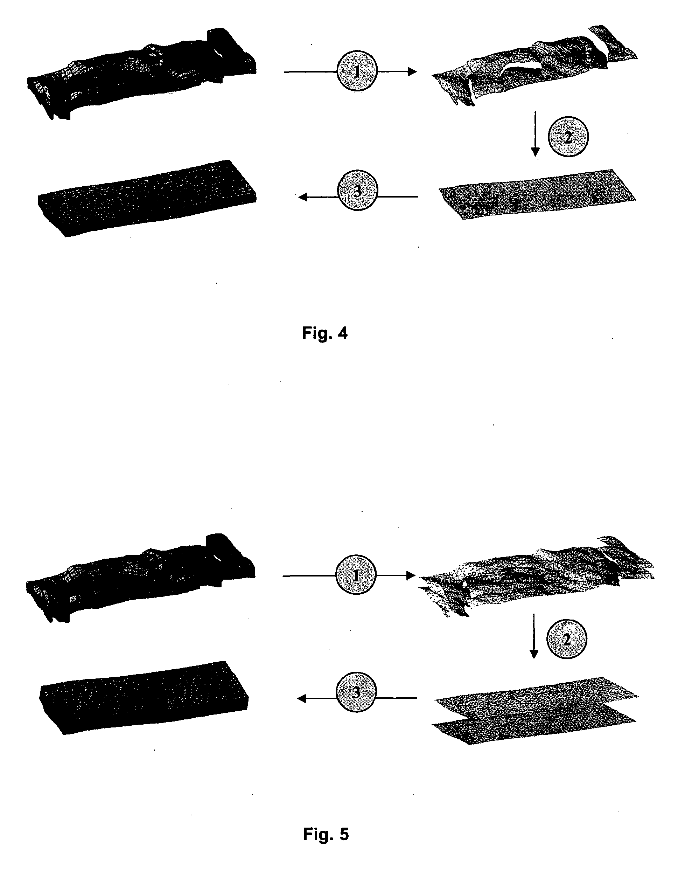

La figure 4 illustre le procédé de dépliage isométrique à partir d'une surface de référence. Selon ce procédé, on déplie une surface de référence, puis on applique une déformation identique à chacune des surfaces de l'unité stratigraphique traitée. Celui-ci comporte les étapes suivantes :

    i) Extraction et triangulation d'une surface de référence choisie par l'utilisateur

    ii) Dépliage isométrique de la surface de référence.

    iii) Construction de l'espace de dépôt en fonction de la déformation calculée lors du dépliage de la surface de référence : déformation des horizons sélectionnés calculée en fonction de la déformation de la surface réalisée lors du dépliage isométrique

A partir de la mise à plat d'une surface de référence choisie par l'utilisateur, les horizons compris entre la base et le toit sélectionnés sont "redressés". Pour cela, chaque point de SR (surface de référence dépliée de façon isométrique) est associé à son pilier correspondant dans le maillage stratigraphique. La déformation calculée pour chacun des points de SR est ensuite appliquée le long de ces piliers.

L'application de cette méthode implique une mise en correspondance entre la surface de référence et chacun des piliers du maillage. Il est donc nécessaire d'assurer que chaque pilier correspond strictement à un point de la surface de référence. Pour cela : (i) les lèvres des failles doivent correctement coïncider (i. e. pas de trou) (ii) la suppression d'arête pour simplifier le maillage triangulaire ne doit pas provoquer de manque d'information.

L'algorithme se déroule selon différentes étapes développées par la suite :

-   correspondance entre les points de la surface de référence triangulée et les noeuds de l'horizon du maillage ;

-   pour chaque point P de la surface de référence :

    •   calcul de la transformation T en P (surface pliée en surface à plat) ;

    •   application de T sur tous les noeuds du pilier passant par P.

### *Correspondance de la surface de référence et du maillage*

Pour appliquer une déformation à chaque noeud du maillage identique à celle réalisée lors du dépliage isométrique de la surface de référence (SR), une mise en correspondance entre les points de SR et les points de la grille est réalisée.

Ainsi, chaque sommet de SR est associé à un pilier du maillage. Cependant, plusieurs sommets peuvent correspondre à un même pilier du maillage. En effet, pour un horizon donné, une discontinuité peut apparaitre au niveau des failles. Cette discontinuité engendre plusieurs sommets d'un même noeud du maillage possédant des coordonnés différentes.

Chacun des points de SR étant distinct, si un même noeud est référencé par plusieurs sommets, ceux-ci sont traités indépendamment. Toutefois, ces sommets nécessitent un traitement particulier afin de ne pas produire de discontinuité dans la grille mise à plat. Ce traitement est détaillé dans la section suivante.

Lors de la triangulation de la surface de référence, certains sommets sont supprimés afin de ne pas construire de triangles de taille nulle. La suppression de ces sommets implique que certains piliers du maillage n'ont pas de point correspondant dans la surface de référence. Cette suppression est engendrée par la proximité de deux sommets du maillage appartenant à la même face (ou maille). Pour définir la correspondance en ces points, le sommet conservé de coordonnés égales est recherché dans le maillage. Celui-ci appartient à la même maille que le sommet supprimé.

Le dépliage isométrique de la surface de référence, ne garantit pas que la surface dépliée soit dans le même repère que la surface de référence. Il est donc nécessaire de vérifier que ces deux surfaces sont bien superposées à la fin du dépliage, et si ce n'est pas le cas, de procéder à un recalage de la surface dépliée par rapport à la surface de référence.

*Calage de la surface dépliée et contrôle visuel de la qualité de la mise en position de dépôt*

On réalise un recalage de la surface dépliée par rapport à la surface pliée correspondante (surface de référence). De cette façon, l'unité stratigraphique en position de dépôt sera superposée à l'unité correspondante en position géographique. Il est donc possible d'évaluer visuellement (ou automatiquement par des logiciels d'analyse d'image) la qualité de la mise en position de dépôt de l'unité stratigraphique, ainsi que des puits qui lui sont associés.

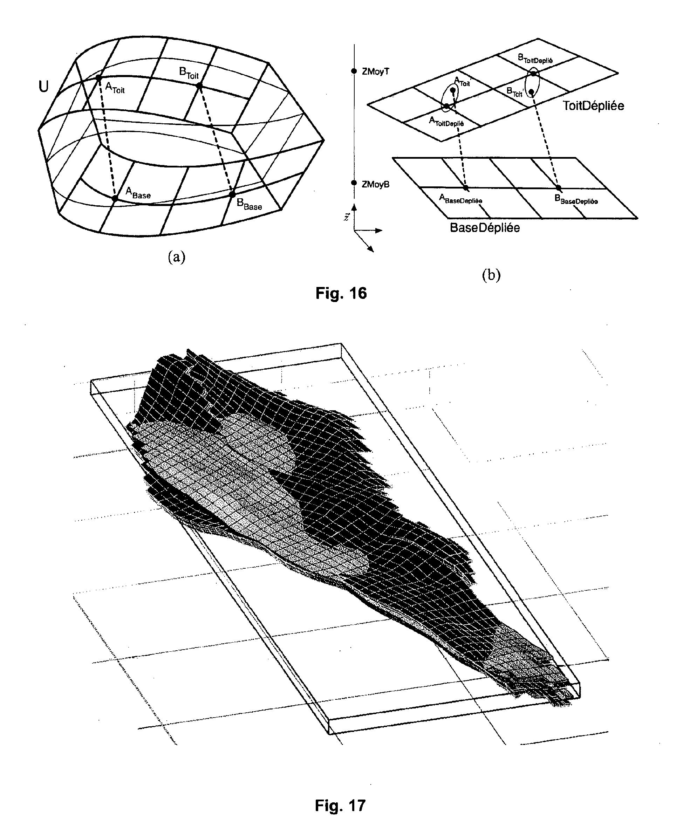

Considérons l'unité stratigraphique U, en position géographique, de la figure 16A. Sur la surface de référence de U, on choisit un ensemble E de sommets satisfaisant au critère C2 suivant : le sommet ne se situe pas sur une faille et il ne se situe pas dans une région érodée. Dans la pratique, une dizaine de sommets suffisent. La surface de référence peut être soit la surface inférieure de l'unité, si l'on souhaite effectuer une mise en position de dépôt parallèle à la surface inférieure (base de l'unité), soit la surface supérieure de l'unité si l'on souhaite faire une mis en position de dépôt parallèle à la surface supérieure (toit de l'unité).

Soit SE le sous-ensemble des sommets qui correspondent à E dans la surface dépliée. Pour réaliser le calage, on cherche à minimiser les distances entre un ensemble de points de la surface dépliée et les points correspondants dans la surface de référence. Pour ce faire, on applique un algorithme de minimisation des écarts des distances, avec comme paramètre l'ensemble des sommets de référence E et l'ensemble des sommets à recaler SE. Le calcul de minimisation étant 2D, seules les coordonnées 2D des sommets de E et de SE sont transmises au calcul. On obtient alors un angle A et une translation T. Un exemple d'algorithme de minimisation des écarts est décrit en annexe.

On applique la transformation d'angle A (par rapport à l'origine du repère 2D) et de translation T à l'ensemble des sommets de la surface de référence.

La dernière étape consiste à placer la surface de référence dépliée dans l'espace 3D. On calcule la profondeur moyenne ZMoy de l'ensemble des sommets de la surface de référence de U qui satisfont le critère C1 suivant : le sommet ne se situe pas sur une faille ; il ne se situe pas dans une région érodée.

On attribue alors à l'ensemble des sommets de la surface dépliée la profondeur ZMoy. La surface dépliée est alors calée avec sa surface correspondante dans l'espace géographique.

Le recalage par minimisation permet ainsi de positionner une unité stratigraphique en position géographique et l'unité correspondante en position de dépôt dans un même espace. On obtient ainsi une correspondance "physique" qui permet une évaluation visuelle de la qualité de la mise en position de dépôt, comme l'illustre la figure 17, sur laquelle l'unité en position géographique est représentée en noir, tandis que l'unité correspondante en position de dépôt est représentée en gris.

*Calcul de transformation au point P*

Afin de traiter sans exception l'ensemble des sommets construits lors de la mise à plat de SR, les piliers du maillage correspondants de la surface sont traitées itérativement (et non l'ensemble des noeuds du maillage).

Pour chaque sommet de SR, deux bases orthonormées sont calculées. L'une par rapport à la surface dépliée, l'autre par rapport à la surface pliée.

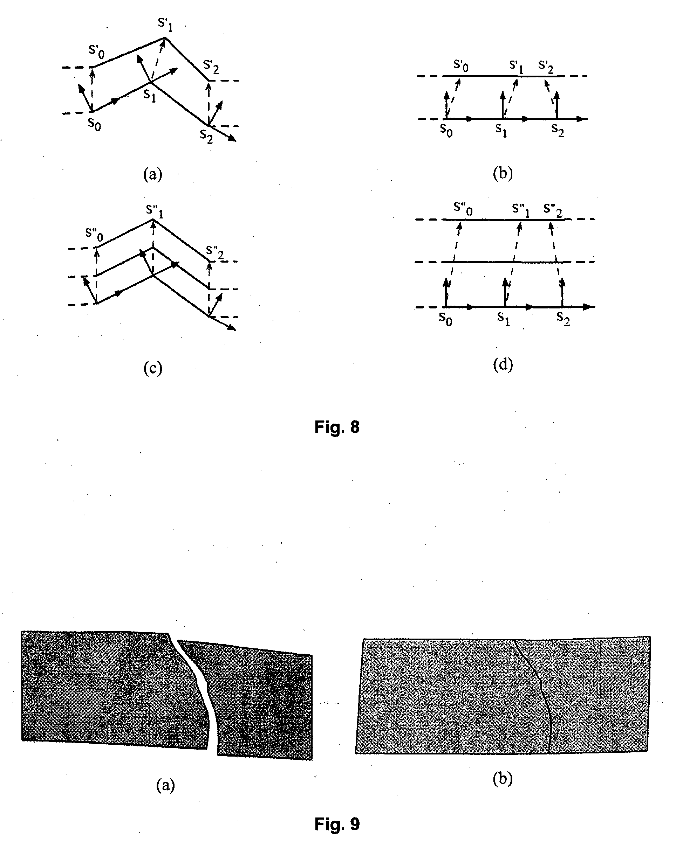

A partir des bases ainsi produites, une transformation par changement de base permet pour chaque point d'un horizon de la grille de déduire sa nouvelle position. La figure 8 illustre le dépliage de trois horizons contenu dans une grille. Dans cet exemple, la surface de référence choisie est la surface 0, et les horizons de 0 à 2 inclus sont dépliés.

*Discontinuité de surface*

Comme expliqué dans la section précédente, la présence des failles entraine des discontinuités dans l'image des surfaces. Ainsi, plusieurs sommets de SR peuvent correspondre aux mêmes noeuds (i, j) de la grille. Dans la méthode de mise à plat de surface, les deux lèvres de chaque faille sont ajustées afin d'avoir une bonne correspondance comme illustré sur la figure 9. Lors de mise à plat, les lèvres des failles sont mises en correspondance afin de ne pas produire de trous dans la surface dépliée.

Cette discontinuité implique des normales Z1 et Z2 différentes au niveau des sommets S1 et S2 de la faille. Pour pallier ce problème, une nouvelle normale est calculée pour chaque couple de sommets du bord de la faille, telle que Z soit la moyenne de Z1 et Z2. Les normales utilisées en S1 et S2 étant égales, les transformations appliquées sont équivalentes. Ainsi, les points S'1 et S'2 résultants ont les mêmes coordonnées X, Y. On peut alors soit laisser la surface dépliée, soit calculer de nouveaux points S"1 et S"2 par interpolation de S'1 et S'2.

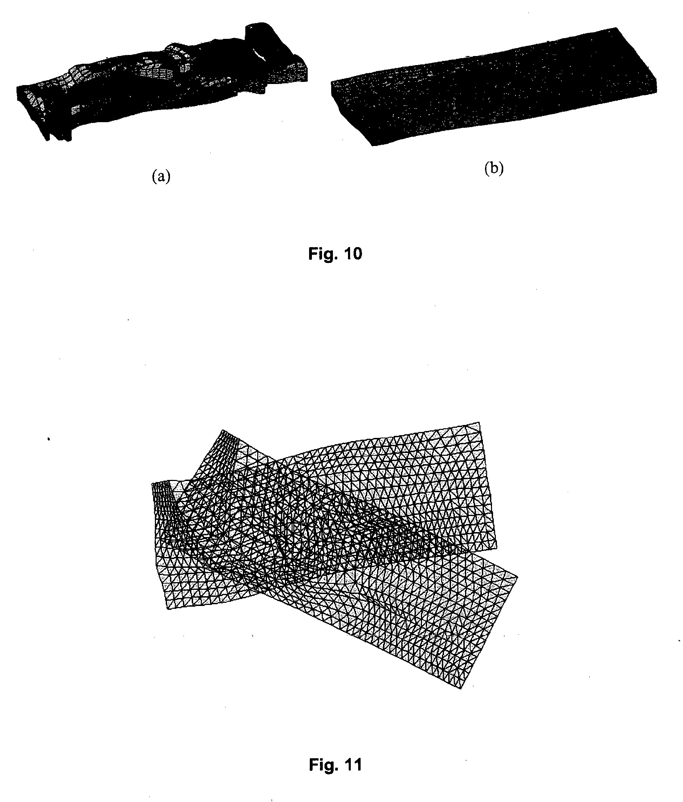

La figure 10 illustre le dépliage isométrique du maillage stratigraphique (à gauche) conduisant à l'espace de dépôt (à droite) selon la méthode de dépliage isométrique à partir d'une surface de référence.

Dépliage isométrique de deux surfaces de référence

La figure 5 illustre le procédé de dépliage isométrique et proportionnel à partir de deux surfaces de référence. Celui-ci comporte les étapes suivantes :

i) Extraction et triangulation des surfaces supérieure et inférieures choisies par l'utilisateur

ii) Dépliage isométrique et calage des deux surfaces dans le même repère

iii) Construction de l'espace de dépôt par interpolation des points le long de piliers du maillage stratigraphique entre les deux surfaces de références.

A partir de la mise à piat des surfaces supérieure (Sroof) et inférieure (Sbase), les positions des surfaces comprises entre ces surfaces sont calculées par interpolation. Pour cela, Sbase et Sroof doivent être positionnés dans le même repère (cela n'est pas garanti par l'algorithme de mise à plat). La construction de l'espace de dépôt comprend donc deux étapes développées par la suite :

•     le calage des surfaces supérieure (Sroof) et inférieure (Sbase) ;

•     le calcul par interpolation des points de la grille entre Sbase et Sroof.

*Calage des surfaces*

Les surfaces dépliées résultantes de la méthode de mises à plat ne sont pas placées dans le même repère comme l'illustre la figure 11. Il est nécessaire de procéder à un recalage afin de les repositionner l'une par rapport à l'autre.

Premier mode de réalisation

Pour caler les deux surfaces, leurs positionnements dans l'espace plié sont calculés pour replacer les surfaces dépliées de manière similaire. Chaque face étant déformée indépendamment au cours du dépliage isométrique, une cellule de référence doit être choisie pour réaliser le calage. Le processus de dépliage est réalisé à partir de la face qui contient le barycentre de la surface. Cette cellule est le point de départ du processus, elle ne subit aucune déformation. C'est pourquoi, le positionnement de Sbase et Sroof, l'une par rapport à l'autre, est calculé à partir de cette même cellule.

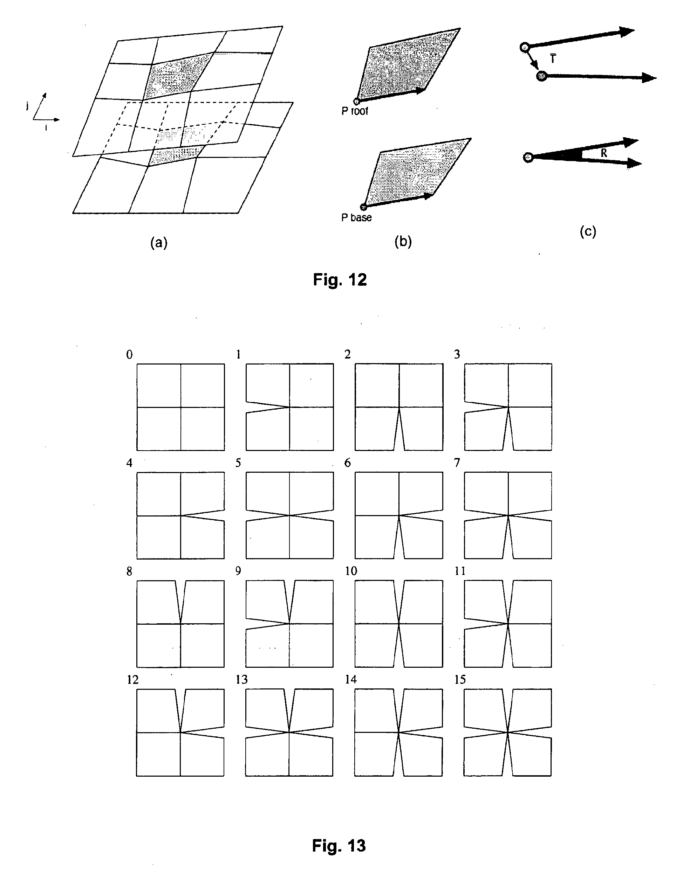

La figure 12 explique le calcul du positionnement de la cellule de référence de Sbase par rapport à la cellule de référence de Sroof : (a) les cellules de référence sont choisies au niveau du barycentre des surfaces ; (b) pour chaque cellule, un point et un vecteur sont définis pour calculer le positionnement ; (c) par projection dans un plan 2D, une translation T et une rotation R sont calculée. Ainsi, deux cellules (i, ,j) sont extraites, l'une de Sbase l'autre de Sroof. Les positionnement de ces deux faces est définie à partir du calcule d'une translation et d'une rotation calculés dans un plan de projection 2D (x,y) (voir figure 12).

Une fois la translation et la rotation connue, chaque point de la surface roof (choisie arbitrairement), est déplacé suivant la même transformation. Pour cela, dans un premier temps, tous les points sont repositionnés afin que Pbase et Proof (voir figure 12) soient superposés. Puis, une transformation T et R sont appliquées.

Remarque : pour utiliser cette méthode, les deux cellules de références choisies doivent exister, dans les deux surfaces. Cette configuration peut intervenir dans deux cas : (i) les barycentres des surfaces ne sont pas contenu dans la même cellule et l'une d'elle n'existe pas, (ii) une érosion est constater dans l'une des surfaces. Dans les deux cas, une nouvelle adresse de cellule de référence doit être choisie, le critère de déformation de celles-ci devant être minimum.

Second mode de réalisation

Dans un premier temps, on recale la surface supérieure dépliée par rapport à la surface inférieure dépliée. Pour cela, on cherche à minimiser les distances entre un ensemble de points de la base dépliée et les points correspondants dans le toit déplié. Au cours de ce processus, on veille à conserver les angles qui existent dans l'unité stratigraphique initiale (en position géographique) entre le toit, la base et les "coordlines" de l'unité. Pour cela, on utilise ponctuellement l'algorithme de mise en position de dépôt basé sur une unique surface de référence. Les "coordlines" sont les lignes verticales qui forment le squelette de la grille qui modélise l'unité. Dans un second temps, afin de minimiser l'erreur produite par le recalage, on répète le processus en choisissant cette fois-ci de recaler la surface de base dépliée par rapport au toit déplié.

Le recalage est décrit en détail selon les étapes 1 à 6 suivantes :

1. Considérons l'unité stratigraphique U, en position géographique, de la figure 16A. Sur la base de U, on choisit un sous-ensemble de sommets qui satisfont les critères C1 suivant : un sommet ne se situe pas sur une faille ; il ne se situe pas dans une région érodée ; il existe un sommet correspondant sur le toit de l'unité. Dans la pratique, une dizaine de sommets suffisent. Par souci de clarté, dans l'exemple de la figure 16A, on choisit seulement les sommets $A_{Base}$ et $B_{Base}$. Soient $A_{Toit}$ et $B_{Toit}$, les sommets qui correspondent respectivement à $A_{Base}$ et $B_{Base}$ sur le toit de l'unité.

2. Soient BaseDépliée et ToitDéplié, respectivement les surfaces 2D de la base et du toit dépliées de l'unité U (voir figure 16B). On choisit de recaler la surface ToitDéplié par rapport à la surface BaseDépliée. Soient $A_{BaseDépliée}$ et $B_{BaseDépliée}$ les sommets de BaseDépliée qui correspondent respectivement à $A_{Base}$ et $B_{Base}$. On utilise l'algorithme de mise en position de dépôt basé sur le dépliage d'une surface de référence afin de repositionner les sommets $A_{Toit}$ et $B_{Toit}$ dans l'espace déplié. On obtient respectivement les sommets $A_{Toit}'$ et $B_{Toit}'$.

3. Soient $A_{ToitDéplié}$ et $B_{ToitDéplié}$ les sommets de ToitDéplié qui correspondent respectivement à $A_{Toit}$ et $B_{Toit}$. On applique l'algorithme de minimisation des écarts défini en ANNEXE, avec comme paramètre l'ensemble des sommets de référence $A_{Toit}'$ et $B_{Toit}'$ et l'ensemble des sommets à recaler $A_{ToitDéplié}$ et $B_{ToiDéplié}$. Le calcul de minimisation étant 2D, seules les coordonnées 2D de $A_{Toit}'$, $B_{Toit}'$, $A_{ToitDéplié}$ et $B_{ToitDéplié}$ sont transmises au calcul. On obtient alors un angle A et une translation T.

4. On applique la transformation d'angle A (par rapport à l'origine du repère 2D) et de translation T à l'ensemble des sommets de la surface ToitDéplié. Les surfaces BaseDépliée et ToitDéplié sont à présent calées l'une par rapport à l'autre dans l'espace 2D.

5. Les étapes 1 à 4 sont répétées en prenant lors de l'étape 1, l'ensemble des sommets initiaux ($A_{Base}$ et $B_{Base}$) sur le toit de l'unité et l'ensemble des sommets correspondants $A_{Toit}$ et $B_{Toit}$ sur la base de l'unité. Ce faisant, on recale la surface BaseDépliée par rapport à la surface ToitDéplié. Cette répétition des étapes 1 à 4 assure une minimisation de l'erreur induite par l'algorithme de recalage.

6. On place alors les surfaces BaseDépliée et ToitDéplié (qui sont à présent calées en 2D) dans l'espace de dépôt 3D. On calcul la profondeur moyenne ZMoyB de l'ensemble des sommets de la base de U qui satisfont le critère C1. On calcul ensuite la profondeur moyenne ZMoyT de l'ensemble des sommets du toit de U qui satisfont le critère C1. On attribut alors à l'ensemble des sommets de BaseDépliée et de ToitDéplié respectivement la valeur z ZMoyB et ZMoyT.

*Calage de la surface de base dépliée pour contrôle visuel de la qualité de la mise en position de dépôt*

Le procédé de recalage de la surface inférieure dépliée par rapport à la surface inférieure pliée, et de la surface supérieure dépliée par rapport à la surface supérieure pliée, est le même que pour recaler la surface de référence et décrite dans le cadre du dépliage isométrique d'une seule surface de référence ("*Calage de la surface dépliée et contrôle visuel de la qualité de la mise en position de dépôt*").

*Calcul de la grille par interpolation*

Le dépliage proportionnel consiste à construire l'ensemble de l'espace de dépôt par un calcul d'interpolation proportionnel des surfaces comprises entre les surfaces de références supérieure et inférieure choisies.

Pour cela, pour chaque point des surfaces le vecteur reliant Pbase à Proof est calculé, puis découpé en N intervalles créant ainsi les N points correspondant aux N horizons compris entre les surfaces Sbase et Sroof.

Le principal avantage de la méthode réside dans la gestion des failles. En effet, les lèvres de celles-ci étant collées au moment du dépliage isométrique de Sbase et Sroof, il n'est pas nécessaire de réaliser de traitements particuliers au cours de la construction de l'espace de dépôt.

Pour chacune des méthodes précédentes, on peut utiliser la technique suivante pour réaliser l'extraction et la triangulation des surfaces.

L'utilisateur isole au sein du maillage stratigraphique à pilier de structure (I, J, K), une unité stratigraphique entre deux valeurs de K : K TOP et K BOTTOM. Cette unité est alors également représentée par un maillage stratigraphique à pilier.

L'utilisateur sélectionne au sein de ce sous maillage un horizon comme surface de référence entre K-TOP et K-BOTTOM. Cet Horizon étant représenté par tous les points du maillage réservoir ayant une même valeur de K quelque soit I et J., ce qui définit une surface.

L'ensemble des faces correspondantes à cette surface est extrait du maillage afin de produire la surface de référence. La surface est ensuite triangulée afin de pouvoir être utilisée pour les algorithmes de mise à plat.

L'extraction des horizons à partir d'un maillage stratigraphique à pilier (I, J, K) s'effectue en deux étapes. Tout d'abord, pour un horizon (couche k d'une grille) et une direction (i. e. faces supérieures ou inférieures), une matrice de face de la taille du nombre de maille pour l'unité considérée est construite. Celle-ci contient les points du futur maillage triangulée. Une correction est ensuite apportée au point de la surface triangulée dont la topologie est incorrecte.

*Construction de la matrice des faces*

Cette matrice contient les faces de chaque maille de l'unité stratigraphique, pour la direction souhaitée. L'intérêt est que chaque face de la matrice contient les références sur les 4 points qui lui sont incidents. Ainsi, la face TOP (resp. BOTTOM) d'une maille du maillage contient 4 indices de sommet numérotés par ordre logique.

Les sommets de la surface sont générés à partir d'un parcours des noeuds incidents aux faces TOP (resp. BOTTOM) des maille de la couche k de la grille. Les sommets de chaque noeud sont parcourus de manière circulaire. A chaque fois qu'un sommet de la grille est parcouru, son abscisse curviligne est comparée au sommet précédent. Si celle-ci est différente, le sommet parcouru génère un nouveau sommet dans la surface.

Remarque : si tous les sommets du noeud ont la même coordonnée curviligne, ces sommets appartiendront au même sommet de la surface générée.

Il est important pour que l'on puisse déplier des surfaces que celles-ci soient "manifold" (i.e. si deux faces sont incidentes à un même sommet, mais ne sont pas incidentes à une même arête). Pour générer des surfaces manifold, il faut appliquer des traitements spécifiques au niveau des noeuds ayant plusieurs composantes connexes de faces incidentes. La correction doit être effectuée sur la matrice de faces, avant la génération de la surface triangulée pour garantir une détection des failles correcte par la suite.

Pour cela, la topologie est corrigée noeud par noeud en "découpant" le maillage (i.e. certain noeud sont dupliqués afin d'éliminer la présence de zone *non-manifold*). Pour chaque noeud, les 4 arêtes incidentes sont testées, un code représentant le type de déconnexion autour de ce noeud est calculé (on ajoute 1 si la première arête est une faille, 2 pour la deuxième, 4 pour la troisième et 8 pour la quatrième). Le code obtenu est compris entre 0 et 15 (figure 13). Une arête est une faille quand l'une au moins de ses extrémités est déconnectée, ou que l'un de ses mailles incidentes est désactivée.

Les cas de découpe (*split*) sont regroupés en 5 catégories, chacun étant associé à une procédure spécifique :

- Dans les cas 0, 1, 2, 4 et 8 : ne rien faire.

- Dans les cas 3, 6, 9 et 12 : faire un split_3_1

- Dans les cas 5 et 10 : faire un split_2_2

- Dans les cas 7, 11, 13 et 14 : faire un split_2_1_1

- Dans le cas 15 : faire un split_1_1_1_1

Soit v0 l'identifiant du sommet courant vu depuis la première face incidente, et v1, v2 et v3 les identifiants vu des deuxième, troisième et quatrième face.

split 3 1 : à une rotation près, on a v0 = v1 = v2

Si v0 = v3, on duplique v3

split 2 2 : à une rotation près, on a v0 = v1 et v2 = v3

Si v0 = v2, on duplique v2 et v3

split 2 1 1 : à une rotation près, on a v0 = v1

Si v0 = v2 ou v3 = v2, on duplique v2

Si v0 = v3 ou v2 = v3, on duplique v3

split 1 1 1 1 :

Si v0 = v1 ou v2 = v1 ou v3 = v1, on duplique v1

Si v0 = v2 ou v1 = v2 ou v3 = v2, on duplique v2

Si v0 = v3 ou v1 = v3 ou v1 = v3, on duplique v3

Remarque : la procédure de duplication de sommet ne doit faire une duplication effective que lorsque l'identifiant de sommet correspond à une maille active.

Afin de conserver les informations explicites contenues dans le maillage stratigraphique, pour chaque noeud découpages, une référence au noeud correspondant du maillage est stockée. Cette donnée permettra de mettre en correspondance les lèvres de faille au cours du dépliage.

*Construction de la surface triangulée*

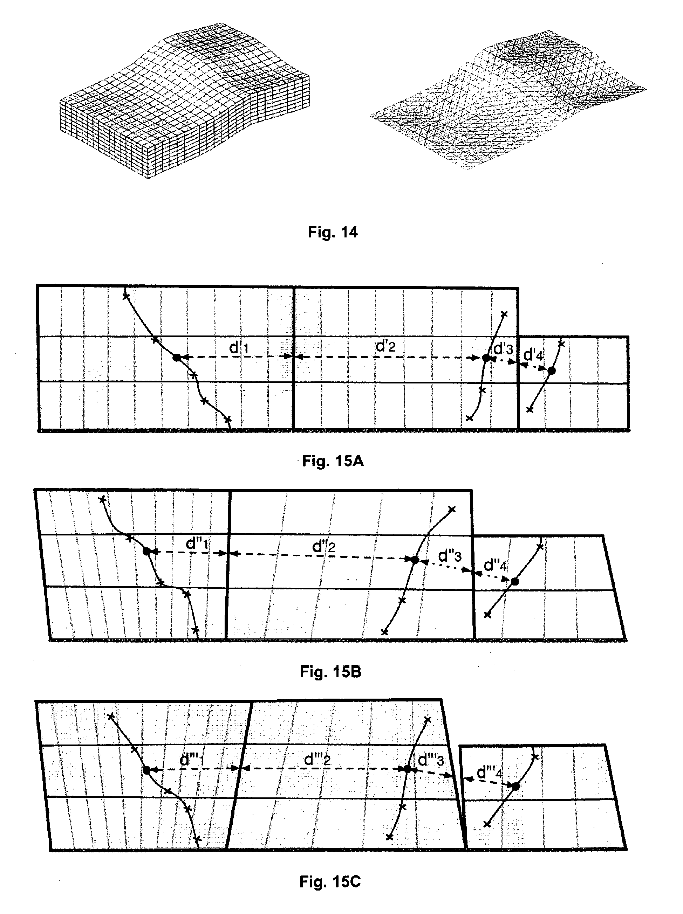

Les triangles sont construits à partir de la matrice de face générée. Pour cela, chaque quadrilatère est scindé en deux par sa diagonale. Les arêtes de taille nulle n'étant pas désirées, si l'arête ajoutée est inférieure à un seuil donné, la seconde diagonale est choisie. De même, si cette découpe entraine la formation de triangle trop petit (incidents à une arête trop petite), le point correspondant est supprimé. Ces suppressions sont prises en compte et documentées, car elles entrainent une mauvaise correspondance entre la grille 3D et la surface triangulée dont il faut se rappeler dans la suite du processus. La figure 14 illustre le résultat de l'extraction d'une surface d'une grille stratigraphique.

3. Mise en position de dépôt de la trajectoire du puits

Au cours de cette étape, on réalise une mise en position de dépôt du ou des puits, en déterminant une position de points définissant la trajectoire du puits au moment du dépôt de la surface de référence choisie à l'étape 2.

Dans un premier temps, le point est localisé dans le maillage stratigraphique (i.e. on détermine la maille (i, j, k) contenant le point). La maille est ensuite maillée en tétraèdres afin de raffiner la localisation. Pour affiner le positionnement, le tétraèdre de la maille (i, j, k) contenant le point à traiter est recherché. Les coordonnées barycentriques du point dans le tétraèdre sont finalement calculées. Grâce aux structures annexes de correspondance, Chaque point de la maille stratigraphique, est associé à un point de l'espace de dépôt (de même pour les sommets des tétraèdres). On appelle "espace de dépôt", l'unité stratigraphique après mise en position de dépôt. Afin de mettre le point du puits en position de dépôt, il suffit de replacer ce point avec les mêmes coordonnées barycentriques dans le tétraèdre correspondant de l'espace de dépôt.

4. Superposition d'une grille cartésienne régulière

Au cours de cette étape, on superpose une grille cartésienne régulière sur l'unité stratigraphique mise en position de dépôt.

Les simulations géostatistiques nécessitent en entrée une grille cartésienne et un ensemble de puits (au moins un) comportant des propriétés. Pour fournir ces données, une grille régulière est construite à partir de l'unité stratigraphique et des puits mie en position de dépôt par rapport à au moins une surface de référence. Cette grille cartésienne englobe l'espace de dépôt, la dimension des maille de la grille est calculée suivant x et y en fonction de la taille moyenne des mailles de l'espace de dépôt suivant ces axes. La hauteur des mailles est calculée en fonction du nombre de couches de même hauteur suivant z souhaité et choisi par l'utilisateur.

Pour minimiser le nombre de maille de la grille cartésienne, celle-ci est orientée en fonction de la position de l'espace de dépôt (et non parallèlement aux axes x et y).

L'espace de dépôt et la grille cartésienne étant placé dans le même repère, les coordonnées géométriques des trajectoires des puits restent inchangées.

5. Remplissage de la grille cartésienne régulière par simulation géostatistique

Au cours de cette étape, on attribue une valeur de la propriété caractéristique de la formation à chaque maille de la grille, à partir de la mesure au puits, du puits mis en position de dépôt et d'une simulation géostatistique.

Le principe de la simulation géostatistique sur une grille cartésienne est bien connu des spécialistes, et rappelé ci-après.

- Tout d'abord, à partir des données statiques (diagraphies, mesures sur des échantillons prélevés dans les puits, sismique...), on définit une fonction aléatoire, caractérisée par sa fonction de covariance (ou de façon analogue par son variogramme), sa variance et sa moyenne.

- Puis, on définit un ensemble de nombres aléatoires tirés indépendamment les uns des autres : il peut s'agir, par exemple, d'un bruit blanc Gaussien ou de nombres uniformes. Il existe donc un nombre aléatoire indépendant par maille et par réalisation.

- Enfin, à partir d'un simulateur géostatistique choisi, et du jeu de nombres aléatoires, un tirage aléatoire dans la fonction aléatoire est effectué, donnant accès à une réalisation (continue ou discrète) représentant une image possible de la formation. Classiquement, le tirage aléatoire est fait dans un cadre hiérarchique. En premier lieu, le modèle géologique est peuplé aléatoirement par une réalisation de la fonction aléatoire associée aux faciès, conditionnellement aux mesures de faciès effectuées ponctuellement. Puis, la porosité est générée aléatoirement sur chacun des faciès, conditionnellement aux données de porosité obtenues sur le faciès considéré. Ensuite, on simule la perméabilité horizontale selon sa fonction aléatoire associée, conditionnellement aux faciès et aux porosités tirées précédemment, ainsi qu'aux mesures de perméabilité effectuées sur le terrain. Enfin, on peuple le modèle géologique par une réalisation aléatoire de la perméabilité verticale conditionnellement à toutes les simulations précédentes et aux données de perméabilité obtenues ponctuellement.

6. Report des propriétés de la grille cartésienne vers le maillage stratigraphique

Au cours de cette étape, on reporte les valeurs attribuées aux mailles de la grille dans les mailles du maillage stratigraphique.

Dans l'espace de dépôt, la grille cartésienne régulière est construite (étape 4) de telle sorte que la taille des mailles corresponde à la taille moyenne des mailles du maillage stratigraphique initial (avant lise en position de dépôt). Ainsi les deux maillages ont en moyenne des mailles de même taille. Pour transférer dans le maillage stratigraphique les propriétés calculées dans l'espace de dépôt (sur la grille cartésienne), pour chaque maille du maillage stratigraphique, on procède comme suit :

- on calcule la position de dépôt C' du centre de la maille C. Ceci est fait en prenant le barycentre des positions de dépôt (calculées à l'étape 2) des huit noeuds de la maille.
De façon générale les positions dé dépôt des noeuds du maillage stratigraphique servent de bases d'interpolation pour le passage entre l'espace défini par le maillage stratigraphique et l'espace de dépôt et pour calcul de l'encombrement (la boite englobante de la grille cartésienne utilisée pour les simulations dans l'espace de dépôt).
- La propriété de la maille du maillage stratigraphique en question est celle de la maille de la grille cartésienne qui contient C' (la localisation se fait par simple règle de trois car le maillage est cartésien régulier).

L'invention est donc réalisée au moyen d'un ordinateur. En effet, les étapes suivantes sont réalisées au moyen de logiciels tels que des géomodeleurs pour l'étape 1, des simulateurs géostatistiques pour l'étape 5. Les étapes 2, 3, 4 et 6 étant réalisées à partir de programmes spécifiques à l'invention.

En revanche, l'étape dans laquelle on mesure au moins une propriété caractéristique de la formation au niveau d'un ou plusieurs puits est bien entendue réalisée au moyen d'outils tels que des sondes diagraphiques, des dispositifs d'acquisition sismiques,...

**Avantages**

La méthode selon l'invention permet de ne mettre à jour qu'une partie du modèle géologique (une seule unité stratigraphique) sans avoir à estimer les propriétés pour l'ensemble du maillage stratigraphique Le fait de pouvoir traiter les unités stratigraphiques indépendamment les unes des autres permet de mettre en oeuvre la méthode de mise à jour du modèle géologique via un calcul parallèle sur différents processeurs.

De plus, la méthode permet une précision accrue dans l'estimation des distances pour définir le variogramme, outil indispensable aux simulations géostatistiques. Une illustration de cet avantage est décrite ci-après

La figure 15A illustre une mise en position (M1) de dépôt avec une méthode connue de l'art antérieur le nombre de mailles est respecté et la valeur moyenne de largeur d'une maille est égale à la moyenne des valeurs des largeurs des mailles de la figure 15A. On obtient des distances $D_1 = d'_1 + d'_2$ et $D_2 = d'_3 + d'_4$

La figure 15B illustre une mise en position (M2) de dépôt avec la méthode de projection verticale : les positions des coins de mailles sont projetées verticalement. Les largeurs des mailles entre la figure 4 et la figure 15B sont donc identiques. On obtient des distances $D_1 = d''_1 + d''_2$ et $D_2 = d''_3 + d''_4$

La figure 15C illustre une mise en position (M3) de dépôt avec la méthode de dépliage isométrique : Les positions des coins des mailles sont entièrement recalculées après avoir mise à plat la surface de référence. Les largeurs de mailles ne sont pas identiques aux mailles du maillage stratigraphique. On obtient des distances $D_1 = d'''_1 + d'''_2$ et $D_2 = d'''_3 + d'''_4$.

Le tableau ci-dessous compare les distances D1 et D2 obtenues après mise en position de dépôt à la distance réelle calculée sur le maillage stratigraphique.

|  | D1 | variation suivant D1 | D2 | variation suivant D2 |
|---|---|---|---|---|
| grille d'origine | 630 | 0% | 270 | 0% |
| M1 | 800 | 26,9% | 150 | 55% |
| M2 | 680 | 7,9% | 250 | 7,5% |
| M3 | 650 | 3% | 260 | 3,2% |

Ce tableau met en évidence que la méthode selon l'invention permet une meilleure estimation des distances. Ceci montre l'importance de son utilisation pour pouvoir analyser correctement les variogrammes et proposer des estimations géostatistiques plus fiables

**ANNEXE**

***Minimisation des écarts entre deux ensembles de points***

L'algorithme de minimisation prend en entrée deux ensembles de points en deux dimensions (2D) munis d'une bijection point à point entre les deux ensembles. Dans la pratique, un tableau 2D de points 2D où la bijection est donnée par les indices du tableau suffit. Le besoin est de superposer globalement les deux ensembles de manière à minimiser l'écart entre les points qui se correspondent (au sens de la bijection). L'algorithme fourni en sortie un angle et une translation qui minimisent les écarts de positionnement dans le plan entre ces deux ensembles de points.

Pour calculer cet angle et ce vecteur, il est appliqué aux deux ensembles de points un algorithme de recadrage par rotation puis translation en minimisant l'erreur quadratique. Il s'agit d'une minimisation de fonction sous contrainte. On résout cette minimisation en utilisant les multiplicateurs de Lagrange. Le résultat est donné sous la forme d'un tableau : [cos, sin, Tx, Ty]

Les deux surfaces sont représentées sous forme de tableau de points $(x_i, y_i)_{i \in I}$ et $(x'_i, y'_i)_{i \in I}$. On veut rapprocher l'ensemble $(x_i, y_i)_{i \in I}$ de l'autre ensemble par l'opérateur T. Ici, l'opérateur consiste en une rotation d'angle θ puis une translation de vecteur $\begin{pmatrix} t_x \\ t_y \end{pmatrix}$ de la surface. Le but est de minimiser la fonction F :

$$F = \sum_{i \in I} \left( x'_i - T(x_i) \right)^2 + \sum_{i \in I} \left( y'_i - T(y_i) \right)^2$$

soit en développant T :

$$F(c, s, t_x, t_y) = \sum_{i \in I} \left( x'_i - \left( t_x + cx_i - sy_i \right) \right)^2 + \sum_{i \in I} \left( y'_i - \left( t_y + sx_i + cy_i \right) \right)^2$$

avec $\begin{cases} c = \cos(\theta) \\ s = \sin(\theta) \end{cases}$

On a donc aussi la contrainte $G(c,s) = c^2 + s^2 - 1 = 0$.

Il s'agit d'une minimisation de fonction sous contrainte. On résout cette minimisation en utilisant les multiplicateurs de Lagrange.

On introduit la fonction $L(c,s,t_x,t_y,\lambda,) = F(c,s,t_x,t_y)-\lambda G(c,s)$

On cherche le point ou la différentielle de $L$ est nulle, soit

$$\begin{cases} (1)\dfrac{\partial L}{\partial t_x} = 0 \\[2ex] (2)\dfrac{\partial L}{\partial t_y} = 0 \\[2ex] (3)\dfrac{\partial L}{\partial c} = 0 \\[2ex] (4)\dfrac{\partial L}{\partial s} = 0 \\[2ex] (5)\dfrac{\partial L}{\partial \lambda} = 0 \end{cases}$$

## Revendications

1. Méthode de construction d'une image d'une formation souterraine traversée par au moins un puits, ladite image comportant un maillage stratigraphique comportant au moins une unité stratigraphique délimitée par une surface supérieure et une surface inférieure et représentant une couche sédimentaire homogène, ladite unité stratigraphique comportant un ensemble de mailles, chaque maille étant définie par un ensemble de noeuds, dans laquelle on mesure au moins une propriété caractéristique de la formation au niveau dudit puits, **caractérisée en ce que** l'on réalise les étapes suivantes :

   i. on réalise une mise en position de dépôt de ladite unité stratigraphique, en déterminant une position des noeuds de mailles de ladite unité au moment du dépôt d'au moins une surface de référence contenue dans ladite unité stratigraphique, en réalisant les étapes suivantes :

   a. on réalise un dépliage isométrique d'au moins ladite surface de référence ;
   b. on définit une rotation et une translation à appliquer à ladite surface dépliée au moyen d'une minimisation de distances entre un ensemble de points de la surface de référence et des points correspondants dans ladite surface dépliée, et l'on applique ladite rotation et ladite translation à ladite surface dépliée, de façon à obtenir une superposition de ladite surface dépliée avec ladite surface de référence ;
   c. on utilise ladite superposition pour réaliser un contrôle visuel de la mise en position de dépôt, puis on applique le même dépliage au sein de ladite unité stratigraphique ;

   ii. on superpose une grille cartésienne régulière sur ladite unité stratigraphique mise en position de dépôt ;
   ii. on attribue une valeur de ladite propriété caractéristique de la formation à chaque maille de ladite grille, à partir de ladite mesure au puits, du puits mis en position de dépôt et d'une simulation géostatistique ;
   iv. on reporte lesdites valeurs attribuées aux mailles de la grille dans les mailles dudit maillage stratigraphique.

2. Méthode selon la revendication 1, dans laquelle on choisit ledit ensemble de points de la surface de référence en choisissant des sommets de ladite surface de référence, chaque sommet ne se situant ni sur une faille, ni dans une région érodée.

3. Méthode selon l'une des revendications précédentes, dans laquelle on positionne la surface de référence dépliée dans un espace tridimensionnel, en calculant une profondeur moyenne d'un ensemble de sommets de la surface de référence, et l'on attribut à l'ensemble des sommets de la surface dépliée ladite profondeur moyenne.

**4.** Méthode selon la revendication 1, dans laquelle on réalise la mise en position de dépôt de l'unité stratigraphique au moyen d'un dépliage isométrique de deux surfaces de référence, suivi d'un calage de chaque surface dépliée par rapport à la surface de référence correspondante et d'un second calage par rotation et translation des deux surfaces de références dépliées l'une par rapport à l'autre, et d'un dépliage proportionnel de surfaces contenues entres les deux surfaces de référence.

**5.** Méthode selon la revendication 4, dans laquelle les deux surfaces de références correspondent à ladite surface supérieure et ladite surface inférieure.

**6.** Méthode selon l'une des revendications 4 à 5, dans laquelle on réalise ledit second calage , en définissant la rotation et la translation à appliquer à une première surface dépliée au moyen d'une minimisation de distances entre un ensemble de points de ladite première surface dépliée et des points correspondants dans ladite seconde surface dépliée, et l'on applique ladite rotation et ladite translation à ladite première surface dépliée, de façon à obtenir une superposition desdites surfaces dépliées.

**7.** Méthode selon l'une des revendications précédentes, dans laquelle on réalise un dépliage isométrique en prenant en compte des failles de ladite formation, en pratiquant une fermeture de lèvres de failles.

**8.** Méthode selon l'une des revendications précédentes, dans laquelle les surfaces sont des surfaces triangulées.

**Patentansprüche**

**1.** Verfahren zur Konstruktion eines Bildes einer unterirdischen Formation, die durch mindestens einen Schacht durchquert wird, wobei das Bild ein stratigraphisches Raster umfasst, das mindestens eine stratigraphische Einheit umfasst, die durch eine obere Fläche und eine untere Fläche abgegrenzt ist und eine homogene Sedimentschicht darstellt, wobei die stratigraphische Einheit eine Menge von Rasterelementen umfasst, wobei jedes Rasterelement durch eine Menge von Knoten abgegrenzt ist, in dem mindestens eine Eigenschaft gemessen wird, die für die Formation im Bereich des Schachts charakteristisch ist, **dadurch gekennzeichnet, dass** die folgenden Schritte ausgeführt werden:

i. Ausführen einer Ablagerungspositionierung der stratigraphischen Einheit durch Bestimmen einer Position der Rasterelementknoten der Einheit zum Zeitpunkt des Ablagerns von mindestens einer Bezugsfläche, die in der stratigraphischen Einheit enthalten ist, durch Ausführen der folgenden Schritte:

a. Ausführen einer isometrischen Entfaltung von mindestens der Bezugsfläche;
b. Definieren einer Drehung und einer Translation, die auf die entfaltete Fläche anzuwenden sind, mittels einer Minimierung von Abständen zwischen einer Menge von Punkten der Bezugsfläche und entsprechenden Punkten in der entfalteten Fläche und Anwenden der Drehung und der Translation auf die entfaltete Fläche, derart, dass eine Überlagerung der entfalteten Fläche mit der Bezugsfläche erhalten wird;
c. Verwenden der Überlagerung zum Ausführen einer Sichtprüfung der Ablagerungspositionierung und dann Anwenden derselben Entfaltung in der stratigraphischen Einheit;

ii. Überlagern eines gleichmäßigen kartesischen Gitters auf der in die Ablagerungsposition gebrachten stratigraphischen Einheit;
iii. Zuordnen eines Werts der Eigenschaft, die für die Formation charakteristisch ist, zu jedem Rasterelement des Gitters, ausgehend von der Messung am Schacht, dem in Ablagerungsposition gebrachten Schacht und einer geostatischen Simulation;
iv. Übertragen der den Rasterelementen des Gitters zugeordneten Werte auf die Rasterelemente des stratigraphischen Rasters,

**2.** Verfahren nach Anspruch 1, wobei die Menge der Bezugsflächenpunkte durch Wählen der Spitzen der Bezugsfläche gewählt wird, wobei jede Spitze sich weder auf einer Verwerfung noch in einer erodieren Region befindet.

**3.** Verfahren nach einem der vorhergehenden Ansprüche, wobei die entfaltete Bezugsfläche in einem dreidimensionalen Raum durch Berechnen einer mittleren Tiefe einer Menge von Spitzen der Bezugsfläche und Zuordnen der mittleren Tiefe zu der Menge der Spitzen der entfalteten Fläche untergebracht wird.

**4.** Verfahren nach Anspruch 1, wobei die Ablagerungspositionierung der stratigraphischen Einheit mittels einer isometrischen Entfaltung von zwei Bezugsflächen ausgeführt wird, auf die eine Einstellung jeder entfaltete Fläche in Bezug zur entsprechenden Bezugsfläche und eine zweite Einstellung durch Drehung und Translation der zwei entfalteten Bezugsflächen in Bezug zueinander und eine Entfaltung folgt, die proportional zu Flächen ist, die zwischen den zwei Bezugsflächen enthalten sind.

**5.** Verfahren nach Anspruch 4, wobei die zwei Bezugsflächen der oberen Fläche und der unteren Fläche entsprechen.

**6.** Verfahren nach einem der Ansprüche 4 bis 5, wobei die zweite Einstellung durch Definieren der Drehung und der Translation, die auf eine erste entfaltete Fläche anzuwenden sind, mittels einer Minimierung von Abständen zwischen einer Menge von Punkten der ersten entfalteten Fläche und entsprechenden Punkten in der zweiten entfalteten Fläche ausgeführt wird und die Drehung und die Translation auf die erste entfaltete Fläche angewandt wird, derart, dass eine Überlagerung der entfalteten Flächen erhalten wird.

**7.** Verfahren nach einem der vorhergehenden Ansprüche, wobei eine isometrische Entfaltung unter Berücksichtigung der Verwerfungen der Formation durch Herstellung eines Verschlusses von Verwerfungsrändern ausgeführt wird.

**8.** Verfahren nach einem der vorhergehenden Ansprüche, wobei die Flächen triangulierte Flächen sind.

**Claims**

**1.** A method of constructing an image of an underground formation traversed by at least one well, said image comprising a stratigraphic grid including at least one stratigraphic unit delimited by an upper surface and a lower surface, and representing a homogeneous sedimentary layer, said stratigraphic unit comprising a set of grid cells, each cell being defined by a set of nodes, wherein at least one property characteristic of the formation is measured at the level of said well, **characterized in that** the following stages are carried out:

i. setting a depositional position of said stratigraphic unit, by determining a position of the cell nodes of said unit at the time of deposition of at least one reference surface contained in said stratigraphic unit, by carrying out the following stages:

a. performing an isometric unfolding of at least said reference surface,
b. defining a rotation and a translation to be applied to said unfolded surface by means of a minimization of distances between a set of points of the reference surface and corresponding points in said unfolded surface, and applying said rotation and said translation to said unfolded surface, so as to obtain a superimposition of said unfolded surface with said reference surface,
c. using said superimposition to achieve visual control of the setting of a depositional position, then applying the same unfolding within said stratigraphic unit,

ii. superimposing a regular Cartesian grid on said stratigraphic unit in depositional position,
iii. assigning a value of said property characteristic of the formation to each cell of said grid, from said well measurement, the well in depositional position and a geostatistical simulation,
iv. transferring said values assigned to the grid cells to the cells of said stratigraphic grid.

**2.** A method as claimed in claim 1, wherein said set of points of the reference surface is selected by selecting vertices of said reference surface, each vertex being neither on a fault nor in an eroded region.

**3.** A method as claimed in any one of the previous claims, wherein the unfolded reference surface is positioned in a three-dimensional space by calculating an average depth of a set of vertices of the reference surface, and said average depth is assigned to the set of vertices of the unfolded surface.

**4.** A method as claimed in claim 1, wherein setting a depositional position of the stratigraphic unit is achieved by means of an isometric unfolding of two reference surfaces, followed by a calibration of each unfolded surface with respect to the corresponding reference surface and by a second calibration through rotation and translation of the two unfolded reference surfaces with respect to one another, and by a proportional unfolding of surfaces contained between the two reference surfaces.

**5.** A method as claimed in claim 4, wherein the two reference surfaces correspond to said upper surface and said lower surface.

**6.** A method as claimed in any one of claims 4 and 5, wherein said second calibration is performed by defining the rotation and the translation to be applied to a first unfolded surface by means of a minimization of distances between a set of points of said first unfolded surface and corresponding points in said second unfolded surface, and said rotation and said translation are applied to said first unfolded surface so as to obtain a superimposition of said unfolded surfaces.

**7.** A method as claimed in any one of the previous claims, wherein an isometric unfolding is performed by taking faults of said formation into account and by carrying out a fault side closure.

**8.** A method as claimed in any one of the previous claims, wherein the surfaces are triangulated surfaces.

**Fig. 1**

**Fig. 2A    Fig. 2B**

**Fig. 3**

Fig. 4

Fig. 5

**Fig. 6**

**Fig. 7**

(a)

(b)

(c)

(d)

**Fig. 8**

(a)

(b)

**Fig. 9**

(a)                                    (b)

**Fig. 10**

**Fig. 11**

**Fig. 12**

**Fig. 13**

**Fig. 14**

**Fig. 15A**

**Fig. 15B**

**Fig. 15C**

**Fig. 16**

**Fig. 17**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2005119304 A
- WO 2003050766 A
- US 20110106507 A1
- US 20020091502 A1

**Littérature non-brevet citée dans la description**

- **LAJAUNIE, CH. et al.** Foliation fields and 3d cartography in geology:principles of a method based on potential interpolation. *Mathematical Geology,* 1997, vol. 29 (4), 571-584
- **CALCAGNO, P. et al.** Geological modelling from field data and geological knowledge - Part I. Modelling method coupling 3D potentialfield interpolation and geological rules. *Physics of the Earth and Planetary Interiors,* 2008, vol. 171 (1-4), 147-157
- **MALLET, J. L.** Space-time mathematical framework for sedimentary geology. *Mathematical Geology,* 2004, vol. 36 (1
- **DULAC J.C.** Advances in chrono-stratigraphic interpretation modelling. *First Break,* 2009, vol. 27